# EUROPEAN PATENT SPECIFICATION

(11) **EP 1 509 777 B1**
(45) Date of publication and mention of the grant of the patent: **22.09.2010**
(21) Application number: 03721116.6
(22) Date of filing: 26.04.2003
(51) Int. Cl.: G01R 31/309, G01R 31/26, H01L 21/60, G01N 21/956

(54) **AUTOMATIC TEACHING METHOD FOR PRINTED CIRCUIT BOARD INSPECTION SYSTEM**
AUTOMATISCHES LEHRVERFAHREN FÜR EIN LEITERPLATTEN-UNTERSUCHUNGSSYSTEM
PROCEDE D'APPRENTISSAGE AUTOMATIQUE POUR SYSTEME D'INSPECTION DE CARTES DE CIRCUITS IMPRIMES

(30) Priority: 29.04.2002 KR 2002023483
(43) Date of publication of application: 02.03.2005
(73) Proprietor: Mirtec Co., Ltd., Suwon-city, Gyeonggi-go 442-813 (KR)
(72) Inventor: JOO, Byoung-Oh, Gyeonggi-go 459-122 (KR); PARK, Sang-Hoo, Suite 801-3, 103 Dong, Gyeonggi-do (KR); JEONG, Joon-Young, Songpa-gu, Seoul 138-200 (KR)
(74) Representative: Mounteney, Simon James
(86) International application number: PCT/KR2003/000851
(87) International publication number: WO 2003/093847

(56) References cited:
- JP-A- 9 309 034
- US-A- 4 677 473
- US-A- 4 805 110
- US-A- 5 145 099
- US-A- 5 822 210

## Description

### BACKGROUND OF THE INVENTION

### Field of the invention

The present invention relates to a method for inspecting the state of parts of a printed circuit board, more particularly, to an automatic teaching method for a printed circuit board mounted inspection system which automatically teaches the inspection system inspection related information according to the type of each printed circuit board.

### Description of Related Art

Generally, a printed circuit board inspection system, as a system for inspecting information on various parts adhered onto a printed circuit board, inspects various soldering defects such as no solder, short, position failing off and lead lift and whether appropriate parts are used or not by applying image processing technology to varieties of defects generated in automatic soldering process of the parts.

However, inspection related information such as name, position and shape of parts according to type of circuit boards used to be taught to the inspection system in full since the soldering positions of various parts and the inspection processing method vary according to the type of board.

Conventionally, the foregoing teaching operation has been undertaken manually, and an inspection window for all parts has been manually arranged before being used after dividing the frame to maintain the number of frames as few as possible in the inspection system and obtaining paths of frame for a new circuit board.

However, the manual teaching operation has problems in that it not only requires lots of time and related knowledge, but also lengthens setup time for a new circuit board model.

On the other hand, although teaching methods using mounter data is introduced into certain inspection systems to solve those problems, automatic teaching cannot be applied in all cases, and it is difficult to correspond coordinates for the mounter data with coordinates for the inspection system since corresponding types of a surface mounter are limited to extremely certain cases. Furthermore, there are problems in that it takes more time to correct the positions thereof since the coordinates for the mounter data are different from that is deviated from, the actual coordinates for the mounted parts due to processing reasons.

JP-A-9309034 and US-A-5822210 each discloses a manufacturing management system. In JP-A-9309034 circuit board data and mounting machine management data are stored in a database. Mounting data are prepared from circuit board data and the mounting machine management data by specifying a mounting machine and converting the mounting data into corresponding mounting machine data. In US-A-5822210 various data files are stored and a mounting data creating unit creates mounting data, using part setting position addresses of the mounting machine contained in setup information and part mounting position coordinates contained in a source data management file.

It is an object of the invention to provide an automatic teaching method for a circuit board inspection system that not only completes a teaching operation within a short time, but also reduces setup time for a new circuit board by enabling accurate automatic teaching using mounter data of parts actually mounted on the circuit board.

The invention provides an automatic teaching method in accordance with claim 1.

The data transform step comprises a step of selecting an editing menu from a main screen provided by program execution; an editing screen display step according selection of the editing menu; a step of calling up mounter data through the editing screen; a step of designating a region to transform data from the called up mounter data list ; a step of inputting concerned items after analyzing the transformed data; and a step of forming a teaching file by storing the transformed data, wherein the automatic teaching method for a circuit board inspection system comprises the steps before the step of calling up mounter data or the step of designating a region to transform data; a step of transforming concerned items after analyzing data to be transformed; and a step of forming a data file for teaching by storing the transformed data, and wherein the automatic teaching method for a circuit board inspection system further comprises a step of setting data transform rule before the step of calling up mounter data or the step of designating a region to transform data.

The coordinate transform step comprises a step of selecting coordinate transform menu from a main screen provided by program execution; a coordinate transform screen display step according to selection of the coordinate transform menu; a step of calling up data file for teaching from the coordinate transform screen; a step of outputting information on the called up data file for teaching; a step of performing approximate coordinate transform through the outputted image data for the purpose of micro-coordinate transform; a step of performing micro-coordinate transform by designating specific parts; and a step of registering the transformed coordinates.

The teaching step comprises a step of selecting teaching menu from main screen provided by program execution; a teaching screen display step according to selection of the teaching menu; a step of proceeding automatic teaching through the teaching screen; and a step of finishing teaching after frame generation.

The the editing screen comprises a mounter data output window for outputting the called up mounter data; an environment setting window which is formed at one side of the mounter data output window to set various parameters for transforming mounter data; and a transform data output window which is formed at one side of the mounter data output window to output transform data for the designated mounter data.

The environment setting window comprises a coordinate reference for setting coordinate system of the mounter data; an direction unit for setting rotational angle unit of the mounter data; a coordinate unit for selecting coordinate unit of the mounter data; a separator for setting symbol for dividing between items of the mounter data; and a mounter type selection part for setting the coordinate reference, direction unit and coordinate unit so that operators reuse the selected mounter type not by setting environment again for the data type stored, but by selecting the mounter type only.

The coordinate transform screen comprises a circuit board image display window for displaying entire images of the circuit board and position of each parts inputted into the data file for teaching in a cross shape and displaying position of specific parts selected in a rectangular shape to distinguish the specific parts from general parts; a coordinate transform information window which is formed at one side of the circuit board image display window to display coordinate transformed information of each parts; a symmetric/rotational button which is formed at one side of the circuit board image display window to correspond images of parts with cross marks through dragging of the mouse with mouse adjusted to coordinate system by performing symmetrical or rotational transform on each of the parts inputted into the data file for teaching; a moving button which is formed at one side of the circuit board image display window to correspond the central point of part images of picture projected on an image display window with part coordinates selected on the coordinate transform information window through dragging of mouse by moving camera to position of parts selected through the coordinate transform information window; and a registration button which is formed at one side of the moving button to register transformed coordinates.

The teaching screen comprises an image display window for displaying images of parts to be taught; an automatic teaching tool window that is formed at one side of the image display window; a part group window which is formed at the upper part of the automatic teaching tool window to display a list of parts having the same name as parts selected from the part group window; part find buttons that are formed at the lower part of the part group window to teach position and region and inspection method of an inspection window to be actually inspected by finding parts that are not taught and moving to position of concerned parts; and a lump-sum teaching button that is installed at the lower part of the part find buttons to automatically form the inspection window.

The automatic teaching in the teaching process comprises the processes of moving a camera to x and y coordinates of parts having the same part names using as a standard part parts a reference name of which is registered in parts listed on the part group window, and automatically forming an inspection window having the same attribute as the standard part at the position using angles of the parts; and forming an inspection window having the same attribute as the standard part using position coordinates and rotation angles of parts to be taught to a position having the highest degree of similarity after grasping degree of similarity for images similar to the standard part found in a candidate region by performing pattern matching in which images for a taught standard part are compared with images for a candidate region of parts to be taught so that the automatically formed inspection window is automatically taught to an actual position of parts on a printing circuit board.

The position and region of the taught inspection window are prevented from being deviated by external factors such as mechanical properties of robot and distortion performance of camera by moving the camera to the center of a frame sequentially according to actual inspection sequence when including the inspection window into a frame formed in the frame generation, and adjusting position of the inspection windows again by pattern matching as in the automatic teaching process for each of the inspection windows to be included by photographing images.

### BRIEF DESCRIPTION OF THE DRAWINGS

Further objects and advantages of the invention can be more fully understood from the following detailed description taken in conjunction with the accompanying drawing in which:
FIG.1 is a flow chart schematically illustrating automatic teaching step according to one embodiment of the present invention;
FIG. 2 is a flow chart illustrating data transform step of the FIG. 1;
FIG. 3 is a flow chart illustrating coordinate transform step of the FIG. 1;
FIG. 4 is a flow chart illustrating teaching step of the FIG. 1;
FIG. 5a is a drawing showing a main screen of automatic teaching program according to one embodiment of the present invention;
FIG. 5b to FIG. 5h are image state diagrams showing the state that a series of editing processes are progressed through editing screen provided from the FIG. 5a;
FIG. 6a to FIG. 6d are image state diagrams showing the state that a series of coordinate transform processes are proceeded through coordinate transform screen provided from the FIG. 5a; and
FIG. 7a to FIG. 7d are image state diagrams showing the state that a series of teaching processes are progressed through teaching screen provided from the FIG. 5a.

### <Explanation of symbols on major parts of the drawings>

| | |
|---|---|
| S1000: data transform step | S2000: coordinate transform step |
| S3000: teaching step | 1: main screen |
| 10: editing screen | 30: coordinate transform screen |
| 50: teaching screen | |

### DETAILED DESCRIPTION OF THE INVENTION

The present invention will now be described in detail in connection with preferred embodiments with reference to the accompanying drawings. For reference, like reference characters designate corresponding parts throughout several views.

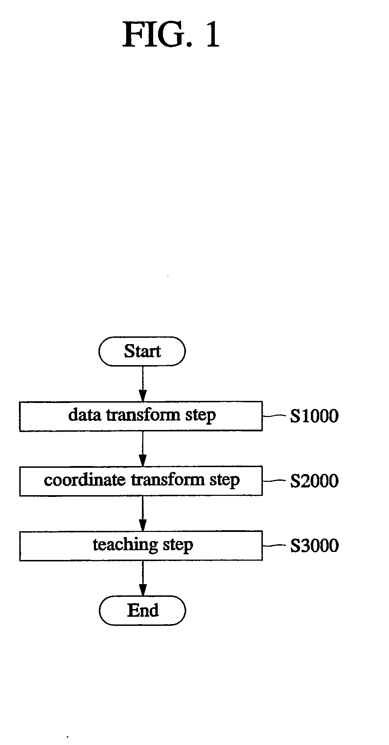

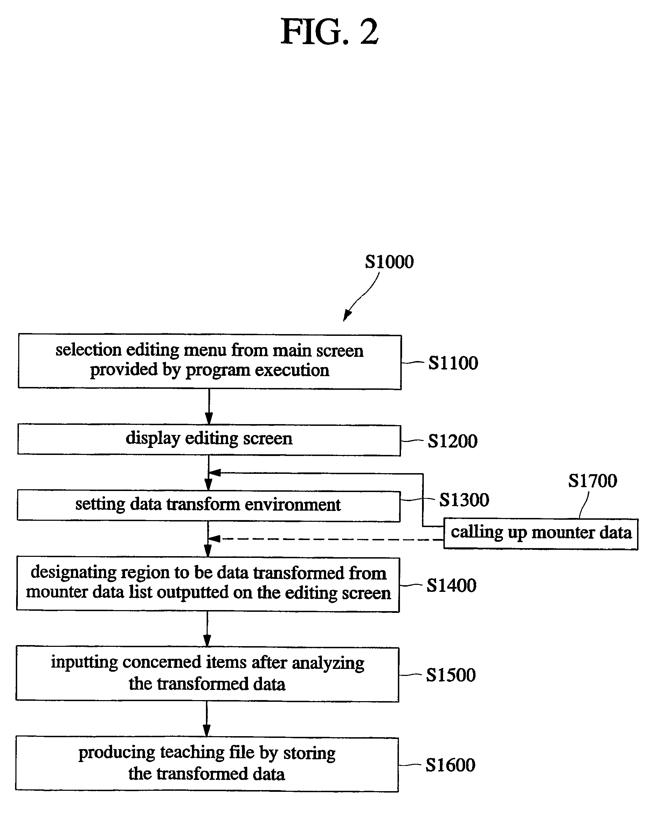

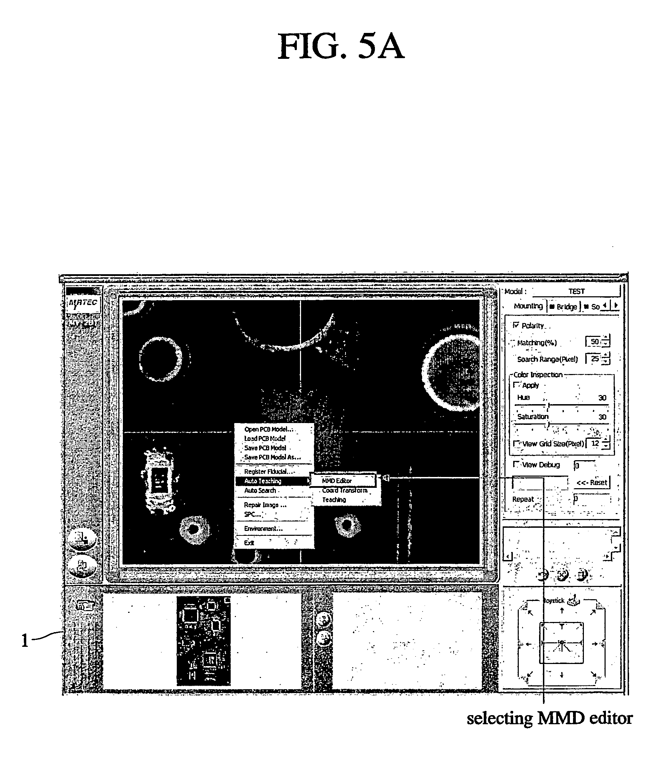

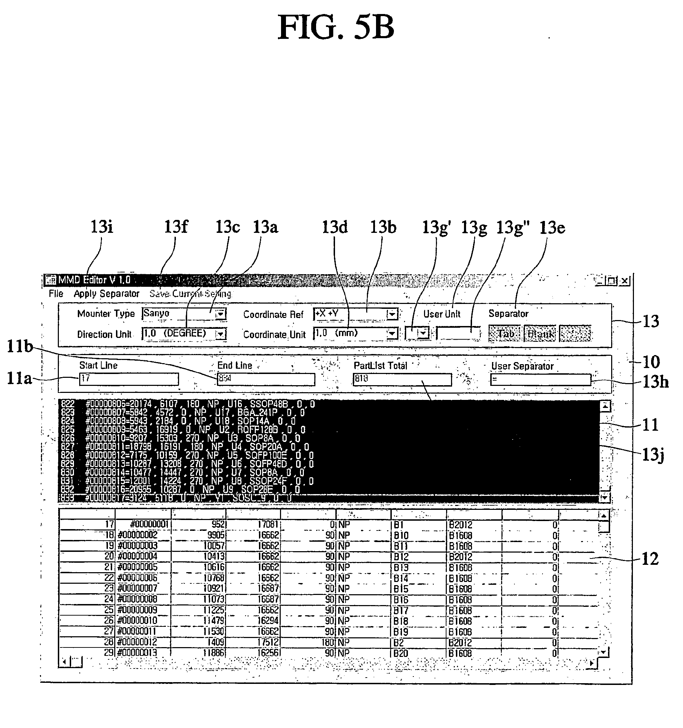

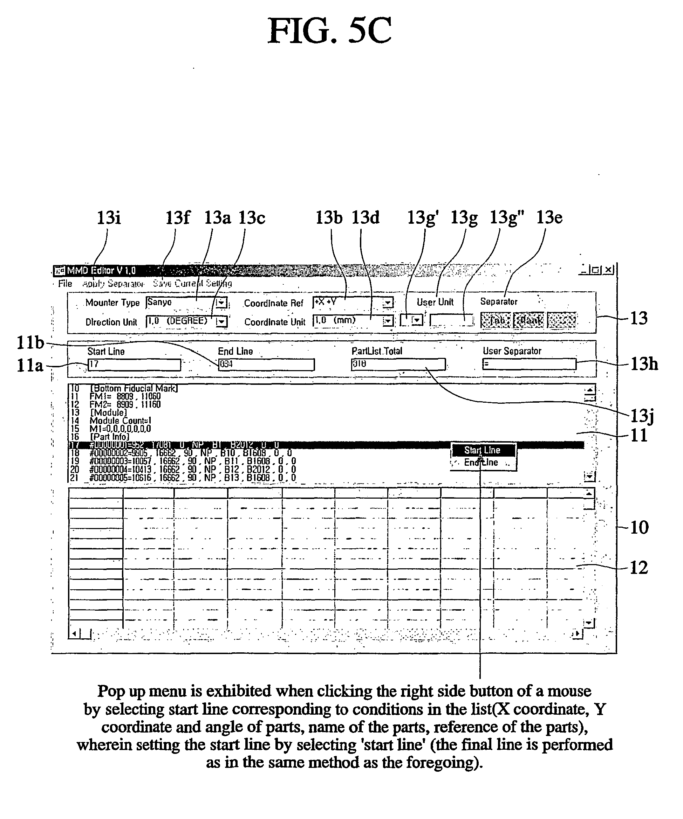

Referring to appending drawings, FIG. 1 to FIG. 7d, constitution and function by one embodiment of the present invention are described more in detail as follows:
As illustrated on FIG. 1, an automatic teaching method for a circuit board inspection system according to one embodiment of the present invention comprises a data transform step (S1000) for transforming mounter data for mounting parts on a circuit board (hereinafter referred to as "mounter data") into data for teaching, a coordinate transform step (S2000) of corresponding coordinates of data for teaching transformed through the data transform step with coordinates of an inspection system for inspecting an actual mounting state of the circuit board, and a teaching step (S3000) of programming contents to be inspected based on data for teaching such as part coordinates, part names reference names and part angles formed through the data transform step (S1000) and coordinate transform step (S2000).
As illustrated in FIG. 2, the data transform step (S1000) comprises a step (S1100) of selecting editing menu after putting a pop up menu on the main screen by pressing the right side button of a mouse when a main screen 1 is outputted as in FIG. 5a as a user executes program as illustrated in FIG. 2, a step (S1200) of displaying an editing screen 10 as in FIG 5b after the step (S1100) of selecting the editing menu, a step (S1300) of calling up mounter data through the editing screen 10, a step (S1400) of designating a region of data to be transformed from the output list when the called up mounter data is outputted through a mounter data output window 11 as illustrated in FIG. 5b, a step (S1500) in which the user transforms concerned items after analyzing the data to be transformed when the region designated data are outputted on a transform data output window 12 installed at the lower part of the mounter data output window 11, and a step (S1600) of forming a data file for teaching by storing the transformed data.
   Furthermore, the data transform step (S1000) further comprises a step (S1700) of setting data transform environment before the step (S1300) of calling up mounter data or the step (S1400) of designating a region for transforming data in the foregoing steps so as to set data transform conditions.
As illustrated in FIG. 5c, region designation in the step (S1400) of designating a region for transforming data is done by selecting a start line corresponding to items to be transformed into the data file for teaching (X coordinate, Y coordinate, angle, name and reference of parts), designating the start line by clicking the right side button of the mouse, and designating an end line by selecting a final line of a region to be transformed as in the same manner.

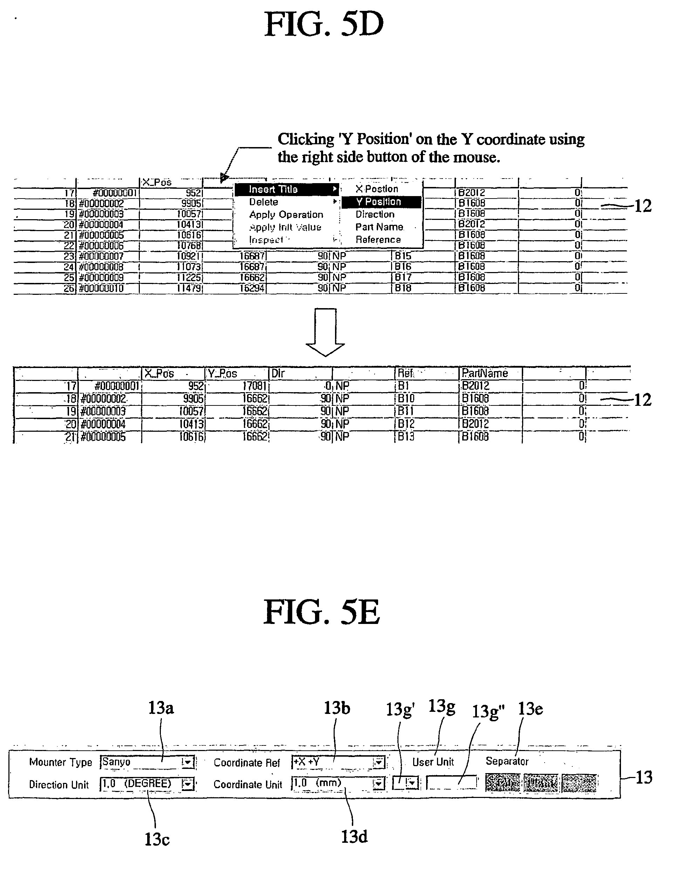

Next, a method for inputting the concerned items in the step (S1500) of transforming concerned items into the data outputted in a transform data output window 120 comprises the steps of positioning the mouse correspondingly to each items, forming a pop up menu window by clicking the right side button of the mouse, and displaying the selected items by clicking name of the concerned items after selecting insert title from the pop up menu as illustrated in FIG. 5d. Item names such as X coordinates, Y coordinates and angles of parts, part name and reference name are displayed by the method.

Next, environmental setting in the environment setting step (S1700) is enabled by inputting data into each designation parts of an environment setting window 13 provided on the editing screen 10 as illustrated in FIG. 5b, 5c and 5e.

The environment setting window 13 comprises a mounter type selection part 13a for selecting types of mounter, a coordinate reference 13b for setting coordinate system of mounter data, a direction unit 13c for setting rotational angle unit of mounter data, a coordinate unit 13d for selecting coordinate unit of mounter data, and a separator 13e for dividing between items of the mounter data.

The operator does clicks a save current setting 13f menu formed at one side of the environment setting window 13 to store environment setting contents after setting and mapping the foregoing coordinate setting part 13b, direction unit selection part 13c and coordinate unit 13d after setting the coordinate reference 13b, direction unit 13c and coordinate unit 13d when an operator transforms mounter data frequently used into a data file for teaching so that the mounter type is used again by operator afterwards not by setting environment for the same data type, but by setting the mounter type only.

The coordinate reference 13b sets a coordinate system used in the mounter, and the coordinate system selected when transforming coordinates into the data file for teaching is transformed into a coordinate system for the inspection system.

The coordinate system is one selected from +x +Y, +X -Y, -X +Y, and -X -Y.

The coordinate unit 13d sets coordinate unit used in the mounter, wherein 1.0 mm, 0.01 mm, 1.0 inch and 1.0 mil are selected as a setting unit of the coordinate unit 13d, and a user column 13g is formed at one side of the coordinate unit 13d. The coordinate units set when transforming the selected setting unit into a data file for teaching are transformed into a micron (µm) unit that is a coordinate unit of the inspection system if one of the setting units is selected.

An operator input column 13g' for inputting an operator and an editor box 13g" for inputting values applied by the user are formed on the user column 13g.

The separator 13e selects tab, blank, rest, or a combination thereof when dividing items of the mounter data so that the items of the mounter data are divided by the tab, blank, rest, or the combination thereof.

The mounter data is read out after dividing items of the mounter data with a selected separator so that a data list is displayed on a mounter data output window.

On the other hand, a user separator column 13h is formed at one side of the separator 13e to read out mounter data, simultaneously use various separators and enter such symbols such as colon between a plurality of separators by dividing items of the mounter data using letters inputted by a user when the separators between the items of the mounter data are not in the separator 13e.

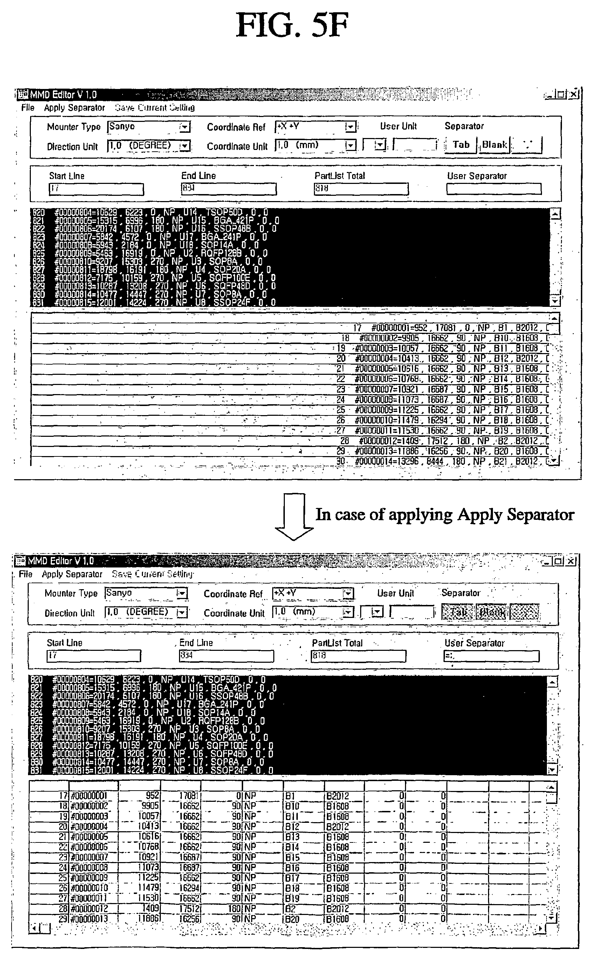

Furthermore, as illustrated in FIG. 5f, an apply separator 13i is formed at one side of the environment setting window 13 so that items are classified by the separator if clicking the apply separator 13i when the separator is not set in the previous step, or the set separator is reset.

In FIG. 5b and 5c, the non-described symbol 13j represents a part list total window for showing the number of parts before being selected.

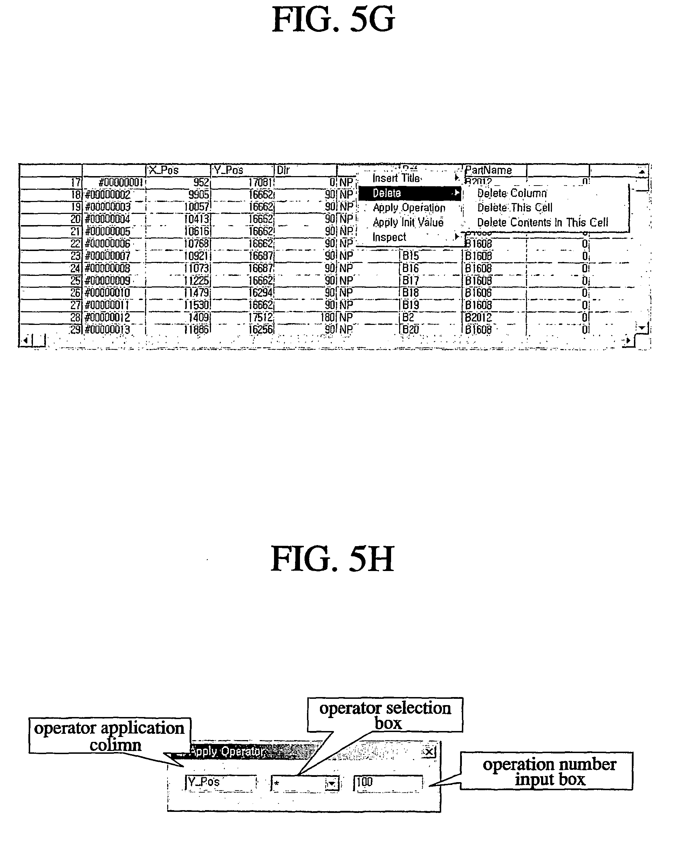

Unnecessary column items are removed from the separated total data in FIG. 5g as a drawing illustrating other examples for editing data of the foregoing transform data output window 12. The column is removed by selecting column to be removed, and selecting column delete of delete item displayed on the pop up menu window by clicking the right side button of the mouse.

Furthermore, a delete this cell menu is formed on the pop up menu window so that a value on the right row is moved to the deleted cell as the selected cell is being deleted when clicking the delete this cell menu after moving the mouse to position of a cell to be deleted.

Furthermore, a menu of delete contents in this cell is formed on the pop up menu window to delete contents of the selected cell.

An operator input window as illustrated in FIG. 5h, a drawing for showing an operator editing example, is appeared by selecting an apply operation menu from the pop up menu window as shown in the FIG. 5g to apply an operator to the selected column by selecting a column.

A column for applying the selected operator and an operator selection box are formed on the operator input window, and an operation number input box for inputting operation number to be applied during operation is formed at one side of the operator input window so that part angle units and coordinate units are manually transformed by a user.

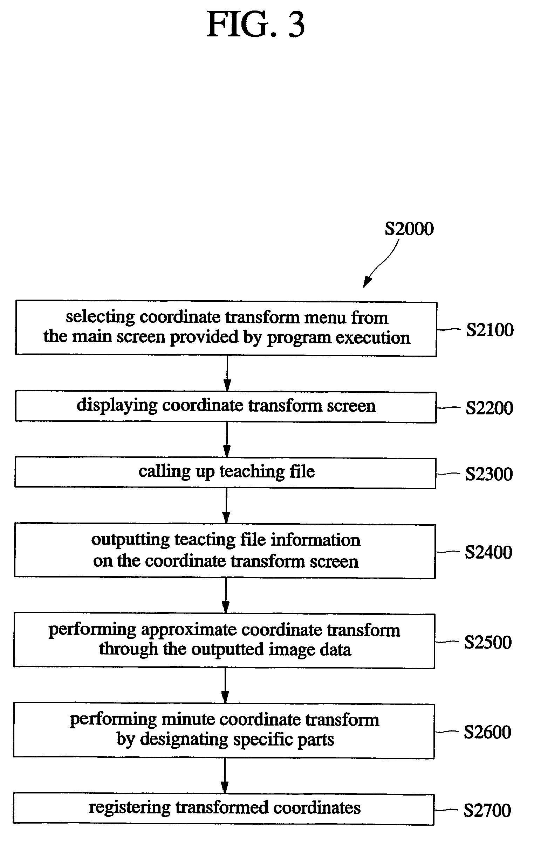

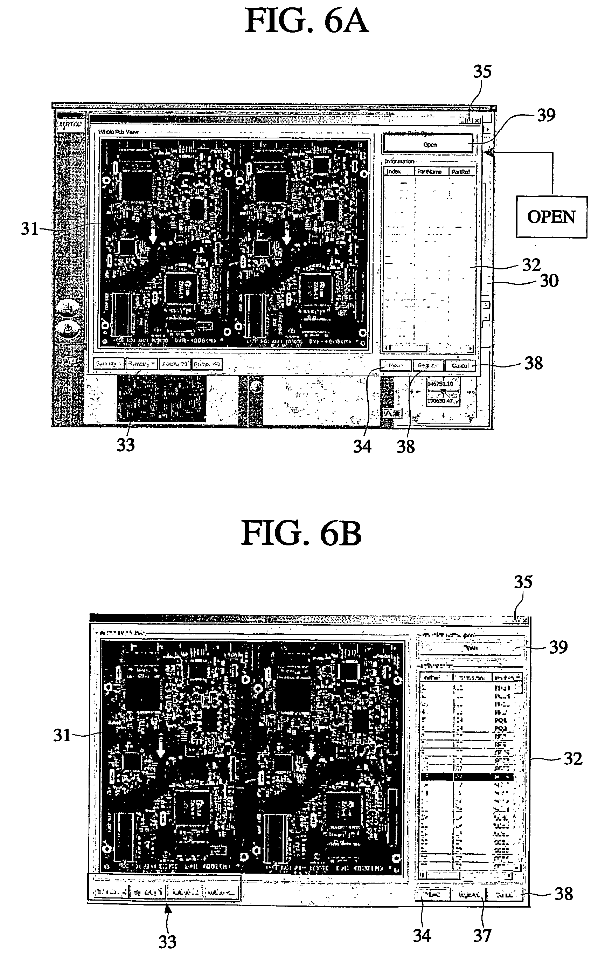

Next, the coordinate transform step (S2000) comprises a step (S2100) of selecting a coordinate transform menu after putting a pop up menu on the main screen 1 by pressing the right side button of the mouse if a main screen 1 as illustrated in FIG. 5a is outputted as the user is executing a program as illustrated in FIG. 3, a step (S2200) of outputting a coordinate transform screen 30 as in FIG. 6a after the step (S2100) of selecting the coordinate transform menu, and a step (S2300) of calling up a teaching file stored the data transform step (S1000) through the coordinate transform screen 30.

Furthermore, the coordinate transform step (S2000) comprises a step (S2400) of outputting information on the teaching file onto the coordinate transform screen 30, a coordinate transform step (S2500) in which a user roughly executes coordinate transform through the called up information on the teaching file, a step (S2600) of executing micro coordinate transform by designating specific parts, and a step (S2700) of registering the transformed coordinates.

A circuit board image display window 31 and a coordinate transform window 32 are formed on the coordinate transform screen 30 in the step (S2300) of calling up the data file for teaching as illustrated in FIG. 6b so that position of each parts inputted into a current data file for teaching is indicated in a cross shape on an image of the circuit board (a part expressed on the screen in black) on the circuit board image display window 31, position of specific parts selected is displayed in a rectangular shape to distinguish the specific parts from ordinary parts, and contents of data file for teaching are displayed on the coordinate transform window 32.

Next, in the coordinate transform step (S2500), position of cross is changed when dragging the mouse to a desired position by clicking the left side button of the mouse in the state that a cross showing part positions on a picture on circuit board images is indicated on the circuit board image display window 31, and data of coordinates transformed as much as displaced position are shown on the coordinate transform window 32 with data of the coordinates being renewed when releasing click of the left side button of the mouse at position where the parts correspond with cross marks.

A micro coordinate transform execution step (S2600) can be performed only by corresponding the cross with the center of all parts of circuit board image of the circuit board image display window 31.

The coordinate transform step (S2500) is also performed through a symmetrical/rotational button 33 formed at one side of the circuit board image display window 31.

That is, symmetrical or rotational transform can be carried out by clicking the symmetrical/rotational button 33 in case that cross distribution shown on the circuit board image display window 31 is symmetrical to part distribution of the circuit board image on the basis of X and Y axes or rotated to angles of +90 degrees and -90 degrees for part distribution of the circuit board image.

The coordinate transform window 32 shows coordinate transformed information of each part, wherein the information comprises index, name, reference, rotational angle, X axis coordinate and Y-axis coordinate of the parts.

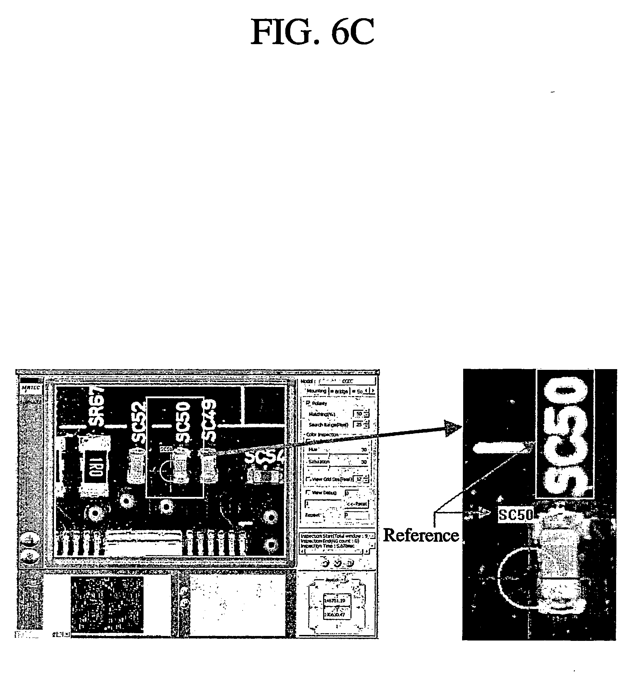

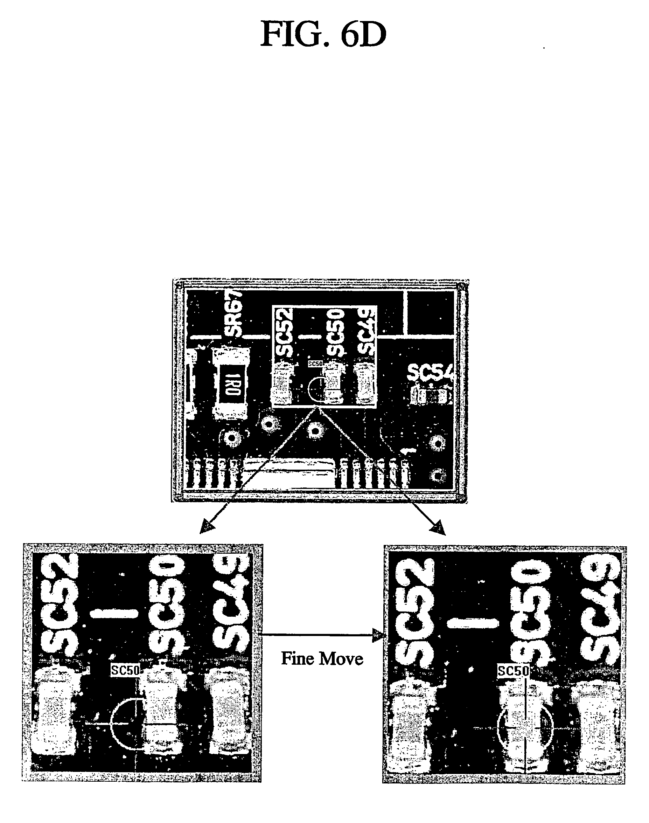

Next, the micro coordinate transform execution step (S2600) is described as follows referring to FIG. 6c and FIG. 6d.

First, a red quadrangle is indicated at position of the part selected on the circuit board image display window 31 to distinguish the specific parts from ordinary parts when a user selects specific parts from a part list of the coordinate transform window 32, and a camera for expanding and projecting an image of the part of the circuit board inspection system is moved to position of selected parts by clicking a move button 34 formed on one side of the coordinate transform window 32.

The coordinate transform screen 30 is closed, and a screen box of parts projected by the camera is outputted on a main screen 1 as in FIG. 6c by clicking a minimization button 35 formed on the upper right side of the coordinate transform screen 30 if the camera is moved.

A cross mark shown on the screen indicates the central position of a part selected from the coordinate transform window 32, wherein micro coordinate transform is executed by moving a camera in the state that the left button of a mouse is clicked in a moving mode so that the center of the part corresponds with the cross marked part as illustrated in FIG. 6d, thereby corresponding the cross mark with the center of the part if a cross mark does not correspond with the central position of a specific part shown on a screen.

A register button 37 is formed at one side of the move button 34 so that the foregoing coordinate transform data is registered by pressing the register button 37.

A register button 37 is formed at one side of the move button 34 so that the foregoing coordinate transform data are registered by pressing the register button (37).

A cancel button 38 is formed at one side of the move button 34 to cancel the coordinate transform process and close a dialogue box.

The non-described symbol 39 represents an open button for calling up a data file for teaching.

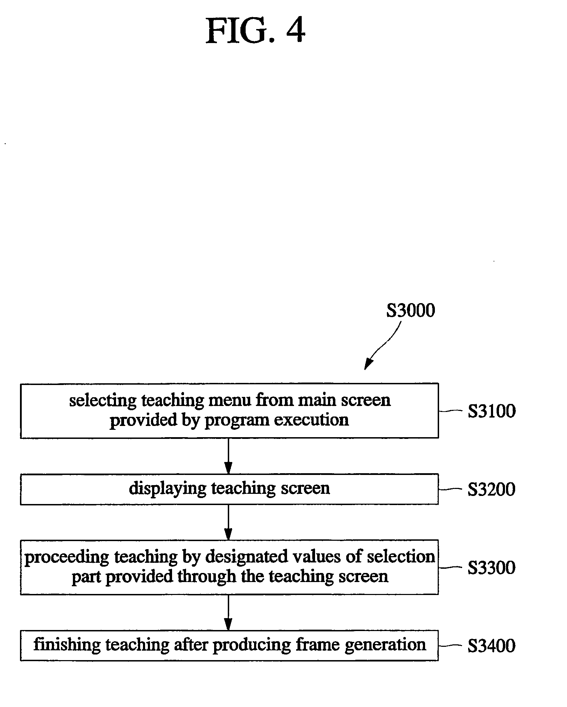

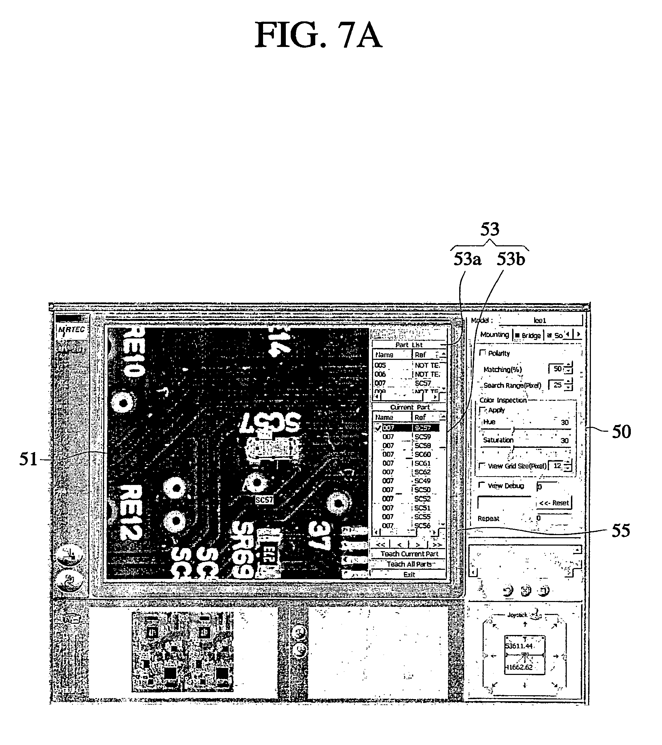

Next, the teaching step (S3000) comprises a step (S3100) of selecting a teaching menu from a main screen 1 provided by program execution as illustrated in FIG. 4, a step (S3200) of showing a teaching screen 50 as in FIG. 7a according to selection of the teaching menu, a teaching proceeding step (S3300) of proceeding teaching by selecting a teaching object, and a step (S3400) of terminating teaching after performing frame generation if teaching proceeding is completed.

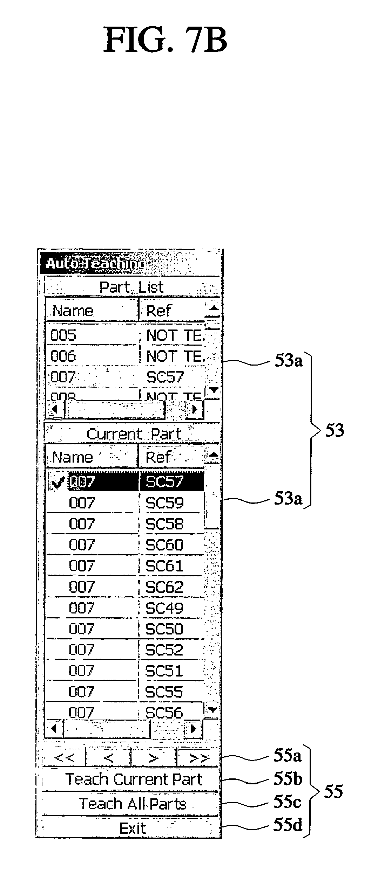

A teaching part indication window 51 for indicating a part to be taught is formed on the teaching screen 50, an automatic teaching tool window is formed at one side of the teaching part display window 51, and an automatic teaching list window 53 and an automatic teaching button part 55 for automatic teaching are formed on the automatic teaching tool window as illustrated in FIG. 7b.

A part group window 53a for showing a list of the whole parts is formed on the automatic teaching list window 53, and a part list window 53b for showing a list of parts having the same name as parts selected from the part group window 53a is formed at the lower side of the part group window 53a.

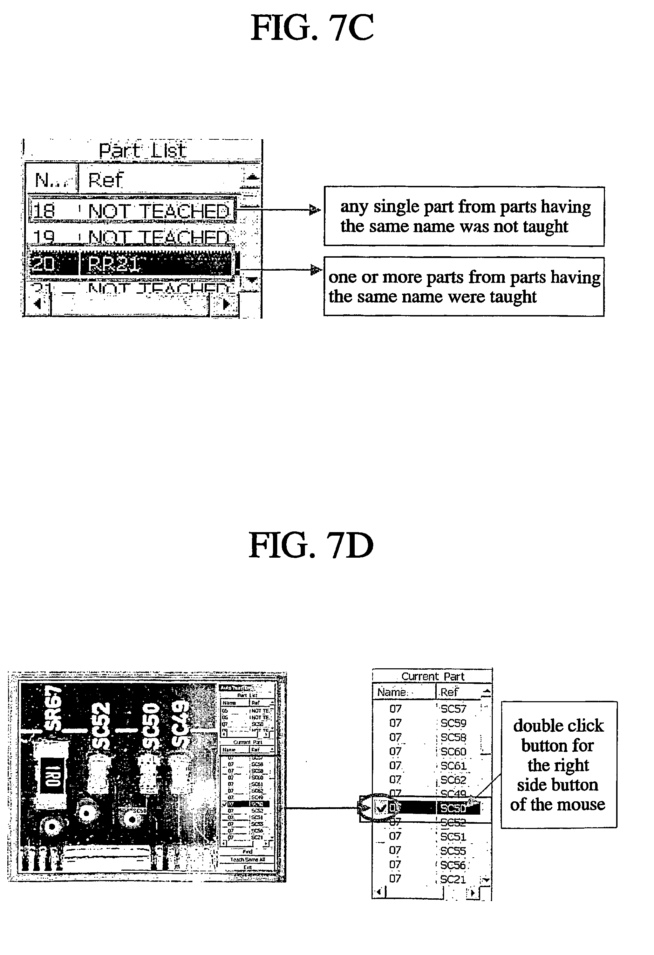

If even one component having the same name as illustrated in FIG. 7c is taught in reference name for each part in the part group window 53a, reference name of a part that is taught very last as having the same name is registered.

On the other hand, the reference name is registered as " NOT TAUGHT" in case that not a single part out of the parts having the same name is taught.

The part list window 53b shows a list of parts having the same name as parts selected from the part group window 53a as illustrated in FIG. 7d, and a camera is moved to position of the selected part when double clicking the left side button of the mouse with a mouse positioned at a part to be taught on the part list window 53b.

After parts to be taught are displayed on the teaching part display window 51, reference names of concerned parts are displayed on the part group window 53a while check marks shown on the concerned parts of the part list window 53b by first teaching a window for mounting state inspection for inspecting position disconnection, defects and mis-insertion of the concerned parts and teaching a window for soldering state inspection of the concerned parts in succession, wherein the window for mounting state inspection should be taught first since the window for soldering state inspection is designated as corresponding data to the window for mounting state inspection.

As illustrated in FIG. 7b, an automatic teaching button 55 comprises a find button 55a that is moved to parts not taught, a teach current part button 55b for finding and automatically teaching parts having the same name as the parts selected from the part group window 53a, a teach all parts button 55c for finding and automatically teaching parts having the same name as all parts of the part group window 53a, and an exit button 55d for finishing automatic teaching after forming a frame.

The find button 55a comprises four buttons of a << button for moving to position thereof to find parts that are not taught among the inspected parts by finding parts that are at the previous positions of currently selected parts from the part group window 53a in reverse order and inspecting parts having the same name as the found parts in order; a < button for moving to position thereof to find parts that are not taught among the inspected parts by inspecting parts that are in the previous position of current selected parts among parts shown on the part list window 53b in reverse order; a >> button for moving to position thereof to find parts that are not taught among the inspected parts by finding parts that are in the following positions of the currently selected parts from the part group window 53a in order and inspecting parts having the same name as the found parts in order; and a > button for moving to position thereof to find parts that are not taught among the inspected parts by inspecting parts that are in the following positions of currently selected parts among parts shown on the part list window 53b in order.

The teach current part button 55b sets the selected parts as a standard part if reference name is registered on parts that are selected from the part group window 53a and finds to automatically teach non-taught parts having the same name as the standard part.

The teach all parts button 55c sets all parts which reference name is registered as a standard part on the part group window 53a in order and finds to automatically teach non-taught parts having the same name as the standard part.

On the other hand, the position of an inspection window formed can be inaccurate as position of an object part to be taught does not accurately corresponds with coordinate data due to various reasons such as error of robot, mounting state of a circuit board and problems of mounting process although automatic teaching is possible only with position coordinates and rotational angles of the object part to be taught.

A pattern matching for comparing image for a standard part that is automatically taught with an image of a candidate region of parts that is to be taught using lump-sum teaching buttons (55b,55c) as a means for solving the foregoing problems is performed so that an inspection window having the same attribute as the standard part is formed on an accurate position of parts using position coordinates and rotational angles of parts that are taught to a position having the highest degree of similarity after grasping degree of similarities for the images similar to the standard part found in the candidate region, and the inspection window is not formed in case that the minimum degree of similarity standard is not satisfied in the whole candidate region so that the inspection window is formed on the next parts having the same attribute as the standard part after they are found.

Next, frame generation is described as follows:
First, frame displays an image photographed once by a camera into a region, wherein the frame generation is meant to minimize the number of frames by optimizing the moving range of the camera, wherein an effect for minimizing inspection time is obtained by minimizing the number of frames.

The automatic teaching step is exited after frames are formed on all inspection windows that are automatically taught to the present time by pressing the exit button 55d when finishing automatic teaching.

The frame generation is a process of forming frames and including the inspection windows included in the formed frames into the frame so that the largest numbers of part units are included for taught inspection windows that are not included in the frame until all inspection windows are included in the frame.

On the other hand, position and region of the inspection window are prevented from being deviated by external factors such as mechanical properties of robot and distortion performance of camera by moving the camera to the center of a frame sequentially according to actual inspection sequence as a position of the formed frame when including the inspection window into the formed frame, and adjusting position of the inspection windows again by pattern matching as in the automatic teaching process for each of the inspection windows to be included by photographing images.

While the invention has been particularly shown and described with reference to preferred embodiments thereof, it will be understood by those skilled in the art that the foregoing and other changes in form and details may be made therein without departing from the scope of the invention, which is set out in the claims.

## Claims

1. An automatic teaching method for a circuit board inspection system comprising:
a data transform step of selecting an editing menu from a main screen provided by program execution by operators, calling up mounter data to the editing screen when mounting a part on the circuit board is performed and designating a region to transform data, and transforming mounter data corresponding to the region to transform data of the designated editing screen into teaching data and storing the results;
a coordinate transform step of corresponding coordinates for data for teaching transformed through the data transform step to inspection system coordinates;
wherein the coordinate transform step is performed by operators by selecting coordinate transform menu displayed on a main screen by program execution, calling up the data for teaching to a coordinate transform screen and designating specific parts and symmetrising or rotating the date for teaching of each of the designated specific part;
a teaching step of programming contents to be inspected based on data for teaching, such as part coordinates, part names, reference names and part angles that are formed through the data transform step and coordinate transform step.

2. The automatic teaching method for a circuit board inspection system according to claim 1, wherein the data transform step comprises:
a first step of selecting an editing menu from the main screen provided by program execution by the user and displaying an editing screen for data transform;
a second step of calling up mounter data to editing screen displayed in the first step;
a third step of designating a region to transform data to be transformed from a mounter data displayed in the editing screen to a data for teaching in the second step;
a fourth step of inputting concerned items for transforming to data for teaching after analyzing the mounter date designated as the region to transform data from the third step;
a fifth step of transforming the designated mounter data input in the fourth step to data for teaching and storing the results as a file for teaching;
a sixth step of transforming concerned items to be transformed to data for teaching from the mounter data after analyzing data to be transformed and called up in the second step;
a seventh step of storing the concerned items transformed in the sixth step and forming a data file for teaching, wherein the sixth and seventh steps are performed between the second step of calling up mounter data and the third step of designating the region to transform data; and
an eighth step of setting data transform rule between the second step of calling up mounter data and the third step of designating a region to transform data.

3. The automatic teaching method for a circuit board inspection system according to claim 1, wherein the coordinate transform step comprises:
an eleventh step of displaying a screen for coordinate transform when a user selects a coordinate transform menu displayed according to program execution;
a twelfth step of displaying the data for teaching stored and transformed in the data transform step on the coordinate transform screen displayed in the eleventh step;
a thirteenth step of performing schematic coordinate transform by dragging the data for teaching displayed on the coordinate transform screen in the twelfth step using a mouse or symmetrising or rotating it;
a fourteenth step of designating specific parts from the data for teaching, on which the schematic coordinate transform is performed in the thirteenth step, moving them to the center of a part that is displayed on an actual image using a mouse, and performing micro-coordinate transform on the specific parts; and
a fifteenth step of registering the transformed coordinates of the specific parts on which the micro-coordinate transform is formed in the fourteenth step.

4. The automatic teaching method for a circuit board inspection system according to claim 1, wherein the teaching step comprises:
a twenty first step of displaying a teaching screen when a user selects a teaching menu from a main screen displayed by a program execution;
a twenty second step of indicating a list subject to teaching on the teaching screen displayed from the twenty first step, selecting a teaching target from the displayed list subject to teaching, and performing teaching on the selected teaching target;
a twenty third step of finishing teaching after frame generation when the teaching performed in the twenty second step is completed.

5. The automatic teaching method for a circuit board inspection system according to claim 2, wherein the editing screen comprises:
a mounter data output window for outputting the mounter data called up from the editing screen of the second step;
an environment setting window which is formed at one side of the mounter data output window such that a user sets various parameters for transforming mounter data; and
a transform data output window which is formed at one side of the mounter data output window to output transform data for the mounter data designated in the third step.

6. The automatic teaching method for a circuit board inspection system according to claim 5, wherein the environment setting window comprises:
a coordinate reference for setting coordinate system of the mounter data;
a direction unit for setting rotational angle unit of the mounter data;
a coordinate unit for selecting coordinate unit of the mounter data;
a separator for setting symbol for dividing between items of the mounter data; and
a mounter type selection part for setting the coordinate reference,
direction unit and coordinate unit so that operators select and reuse the selected mounter type not by setting environment again for the data type stored, but by selecting the mounter type only.

7. The automatic teaching method for a circuit board inspection system according to claim 3, wherein the coordinate transform screen comprises:
a circuit board image display window for displaying entire images of the circuit board and position of each parts inputted into the data file for teaching in a cross shape and displaying position of specific parts selected in a rectangular shape such that the specific parts are distinguished from general parts;
a coordinate transform window which is formed at one side of the circuit board image display window to display coordinate transformed information of each parts;
a symmetric/rotational button which is formed at one side of the circuit board image display window and enables symmetrical or rotational transform to be performed on each of the parts input into the data file for teaching to correspond images of parts with cross marks through dragging of the mouse with mouse adjusted to coordinate system;
a moving button which is formed at one side of the circuit board image display window and enables a camera to move to the position of parts displayed on the coordinate transform window to correspond the central point of part images of picture projected on an image display window with part coordinates selected on the coordinate transform information window by dragging of mouse performed by operators; and
a registration button which is formed at one side of the moving button and enables transformed coordinates to be registered.

8. The automatic teaching method for a circuit board inspection system according to claim 4, wherein the teaching screen comprises:
an image display window for displaying images of parts to be taught;
an automatic teaching tool window that is formed at one side of the image display window;
a part group window which is formed at the upper part of the automatic teaching tool window and displays a list of whole parts;
a part list window which is formed at a lower part of the part group window and displays a list of parts having the same name as those of selected parts among the whole parts displayed on the part group window;
part find buttons that are formed at the lower part of the part group window and enable a position, a region and an inspection method of an inspection window to be taught when parts that are not taught and do not move to position of concerned parts are searched;
and a lump-sum teaching button that is installed at the lower part of the part find buttons to automatically form the inspection window.

9. The automatic teaching method for a circuit board inspection system according to claim 8, wherein the automatic teaching in the teaching process comprises the processes of:
moving a camera to x and y coordinates of parts having the same part names as parts that use a reference name which is registered in each parts listed on the part group window as a standard name, and automatically forming an inspection window having the same attribute as the standard name at the position to which the camera moves using angles of the parts; and
forming an inspection window having the same attribute as the standard part using position coordinates and rotation angles of parts to be taught to a position having the highest degree of similarity after grasping degree of similarity for images similar to the standard part found in a candidate region by performing pattern matching in which images for a taught standard part are compared with images for a candidate region of parts to be taught such that the inspection window automatically formed in the previous step is automatically taught to an actual position of parts on a printing circuit board.

## Patentansprüche

1. Automatisches Lehrverfahren für ein Leiterplatten-Untersuchungssystern, umfassend:
einen Datenumwandlungsschritt zum Auswähler eines Bearbeitungsmenüs aus einem Hauptbildschirm, der durch Programmausführung durch Operatoren bereitgestellt wird, Aufrufen von Bestückerdaten auf den Bearbeitungsbüdschirm, wenn Bestücken eines Teils der Leiterplatte durchgeführt wird, und Zuweisen einer Region zur Umwandlung von Daten, und Umwandeln von Bestückerdaten korrespondierend mit der Region zur Umwandlung der Daten des zugewiesenen Bearbeitungsbildschirms in Lehrdaten und die Ergebnisse speichern;
einen Koordinatenumwandlungsschritt zur Umwandlung, durch den Datenumwandlungsschritt, der korrespondierenden Koordinaten der Lehrdaten zu Untersuchungssystemkoordinaten;
wobei der Koordinatenumwandlungsschitt durch Operatoren ausgeführt wird, indem ein Koordmatenumwandimigsmenü ausgewählt wird, das auf einem Hauptbildschirm durch Frogrammausfuhrung angezeigt wird, die Lehrdaten auf einen Koordinatenumwandlungsbildschirm aufgerufen werden und spezifische Teile zugewiesen und die Lehrdaten von jedem der zugewiesenen spezifischen Teile symmetrisch gemacht oder gedreht werden;
einen Lehrschritt zum Programmieren von Inhalten, die untersucht werden sollen, basierend auf Lehrdaten wie Teilekoordinaten, Teilenamen, Referenznamen und Teilewinkeln, die durch den Datenurnwandlungsscluitt und Koordinatenumwandlungsschritt gebildet werden.

2. Automatisches Lehrverfahren für ein Leiterplatten-Untersuchungssystem nach Anspruch 1, wobei der Datenumwandlungsschritt umfasst:
einen ersten Schritt zum Auswählen eines Bearbeitungsmenüs aus dem Hauptbildschirm, der durch Programmausführung durch den Benutzer bereitgestellt wird, und Anzeigen eines Bearbeitungsbildschirms für Datenumwandlung;
einen zweiten Schritt zum Aufrufen von Bestückerdaten auf den Bearbeitungsbildschirm, der in dem ersten Schritt angezeigt wird;
einen dritten Schritt zum Zuweisen einer Region, um Daten umzuwandeln, die von Bestückerdaten, die auf dem Bearbeitungsbildschirm in dem zweiten Schritt angezeigt werden, zu Lehrdaten umzuwandeln sind;
einen vierten Schritt zum Eingeben betreffender Elemente zum Umwandeln in Lehrdaten nach dem Analysieren der Bestückerdaten, die in dem dritten Schritt als Region zum Umwandeln von Daten zugewiesen wurden;
einen fünften Schritt zum Umwandeln der zugewiesenen Bestückerdaten, die in dem vierten Schritt eingegeben wurden, in Lehrdaten und Speichern der Ergebnisse als eine Lehrdatei;
einen sechsten Schritt zum Umwandeln betreffender Elemente, die aus den Bestückerdaten in Lehrdaten umzuwandeln sind, nach Analysieren der Daten, die umzuwandeln sind und in dem zweiten Schritt aufgerufen wurden;
einen siebten Schritt zum Speichern der betreffenden Elemente, die in dem sechsten Schritt umgewandelt wurden, und Bilden einer Lehrdatendatei, wobei der sechste und siebte Schritt zwischen dem zweiten Schritt zum Aufrufen von Bestückerdaten und dem dritten Schritt zum Zuweisen der Region zur Umwandlung von Daten ausgeführt werden; und
einen achten Schritt zum Einstellen einer Datenumwandlungsregel zwischen dem zweiten Schritt zum Aufrufen von Bestückerdaten und dem dritten Schritt zum Zuweisen einer Datenumwandlungsregion.

3. Automatisches Lehrverfahren für ein Leiterplatten-Untersuchungssystem nach Anspruch 1, wobei der Koordinatenumwandlungsschritt umfasst:
einen elften Schritt zum Anzeigen eines Bildschirms für Koordinatenumwandlung, wenn ein Benutzer ein Koordinatenumwandlungsmenü auswählt, das gemäß Programmausführung angezeigt wird;
einen zwölften Schritt zum Anzeigen der Lehrdaten, die in dem Datenumwandlungsschritt gespeichert und umgewandelt wurden, auf dem Koordinatcnumwandlungsbildschirm, der in dem elften Schritt angezeigt wurde;
einen dreizehnten Schritt zum Ausführen schematischer Koordinatenumwandlung durch Ziehen der Lehrdaten, die auf dem Koordinatenumwandlungsbildschirm in dem zwölften Schritt angezeigt werden, unter Verwendung einer Maus, oder indem sie symmetrisch gemacht oder gedreht werden;
einen vierzehnten Schritt zum Zuweisen spezifischer Teile aus den Lehrdaten, mit denen die schematische Koordinatenumwandlung in dem dreizehnten Schritt ausgeführt wird, Bewegen der Teile unter Verwendung einer Maus zu der Mitte eines Teils, das als tatsächliches Bild angezeigt wird, und Ausführen von Mikro-Koordinatenumwandlung mit den spezifischen Teilen; und
einen fünfzehnten Schritt zum Registrieren der umgewandelten Koordinaten der spezifischen Teile, mit denen die Mikro-Koordinatenumwandlung in dem vierzehnten Schritt gebildet wird.

4. Automatisches Lehrverfahren für ein Leiterplatten-Untersuchungssystem nach Anspruch 1, wobei der Lehrschritt umfasst:
einen einundzwanzigsten Schritt zum Anzeigen eines Lehrbildsehirms, wenn ein Benutzer ein Lehrmenü von einem Hauptbildschirm auswählt, der durch eine Prograromausführung angezeigt wird;
einen zweiundzwanzigsten Schritt zum Angeben einer Liste, die dem Lehren ausgesetzt wird, auf dem Lehrbildschirm, der in dem einundzwanzigsten Schritt angezeigt wurde, Auswählen eines Lehrziels aus der angezeigten Liste, die dem Lehren ausgesetzt wird, und Durchführen von Lehren mit dem ausgewählten Lehrziel;
einen dreiundzwanzigsten Schritt zum Beenden des Lehrens nach Rahmenerzeugung, wenn das in dem zweiundzwanzigsten Schritt ausgeführte Lehren abgeschlossen ist.

5. Automatisches Lehrverfahren für ein Leiterplatten-Untersuchungssystem nach Anspruch 2, wobei der Bearbeitungsbildschirm umfasst:
ein Bestückerdaten-Ausgabefenster zum Ausgeben der Bestückerdaten, die aus dem Bearbeitungsbildschirm des zweiten Schritts aufgerufen wurden;
ein Umgebungs-Einstellungsfenster, das an einer Seite des Bestückerdaten-Ausgabefensters derart gebildet wird, dass ein Benutzer verschiedene Parameter zum Umwandeln von Bestückerdaten einstellt; und
ein Umwandlungsdaten-Ausgabefenster, das an einer Seite des Bestückerdaten-Ausgabefensters gebildet wird, um Umwandlungsdaten für die Bestückerdaten, die in dem dritten Schritt zugewiesen wurden, auszugeben.

6. Automatisches Lehrverfahren für ein Leiterplatten-Untersuchungssystem nach Anspruch 5, wobei das Umgebungs-Einstellungsfenster umfasst:
eine Koordinatcnreferenz zum Einstellen eines Koordinatensystems der Bestückerdaten;
eine Richtungseinheit zum Einstellen einer Drehwinkeleinheit der Bestückerdaten;
eine Koordinateneinheit zum Auswählen einer Koordinateneinheit der Bestückerdaten;
einen Separator zum Einstellen eines Symbols zum Unterteilen zwischen Elementen der Bestückerdaten; und
einen Bestückertyp-Auswahlteil zum Einstellen der Koordinatenreferenz, Richtungseinheit und Koordinateneinheit, so dass Operatoren den ausgewählten Bestückertyp nicht durch erneutes Einstellen der Umgebung für den gespeicherten Datentyp wählen und wiederverwenden, sondern nur durch Auswählen des Bestückertyps.

7. Automatisches Lehrverfahren für ein Leiterplatten-Untersuchungssystem nach Anspruch 3, wobei der Koordmatenumwandlungsbildschirm umfasst:
ein Leiterplattenbild-Anzeigefenster zum Anzeigen vollständiger Bilder der Leiterplatte und Position der einzelnen Teile, die in die Lehrdatendatei eingegeben wurden, in einer Kreuzform, und Anzeigen der Position von spezifischen Teilen, die in einer rechtwinkligen Form ausgewählt wurden, so dass die spezifischen Teile von allgemeinen Teilen unterschieden werden;
ein Koordinatenumwandlungsfenster, das an einer Seite des Leiterplattenbild-Anzeigefensters gebildet wird, zum Anzeigen von koordinatenumgewandelten Teilen der einzelnen Teile;
eine Symmetrie/Drehmig-Schaltfläche, die an einer Seite des Leiterplattenbild-Anzeigefensters gebildet wird und gestattet, symmetrische oder drehende Umwandlung an jedem der Teile, die in die Lehrdatendatei eingegeben wurden, durchzuführen, um Bilder von Teilen mit Kreuzmarkierungen durch Ziehen der Maus in Übereinstimmung zu dringen, wobei die Maus an das Koordinatensystem angepasst wurde;
eine Bewegung-Schaltfläche, die an einer Seite des Leiterplattenbild-Anzeigefensters gebildet wird und gestattet, dass eine Kamera zu der Position von Teilen, die in dem Koordinatenumwandlungsfenster angezeigt werden, bewegt wird, um den Mittelpunkt von Teilbildern von Abbildungen, die auf ein Bildanzeigefenster projiziert werden, mit Teilkoordinaten, die in dem Koordinatenumwandlungs-Informationsfenster ausgewählt wurden, durch Ziehen der Maus, das durch Operatoren ausgeführt wird, in Übereinstimmung zu bringen; und
eine Registrierung-Schaltfläche, die an einer Seite der Bewegung-Schaltfläche gebildet wird und gestattet, umgewandelte Koordinaten zu registrieren.

8. Automatisches Lehrverfabren für ein Leiterplatten-Untersuchungssystem nach Anspruch 4, wobei der Lehrbildschirm umfasst:
ein Bildanzeigefenster zum Anzeigen von Bildern von Teilen, die zu lehren sind;
ein Automatiklehrwerkzeugfenster, das an einer Seite des Bildanzeigefensters gebildet wird;
ein Teilegruppenfenster, das an dem oberen Teil des Automatiklehrwerkzeugfensters gebildet wird und eine Liste von ganzen Teilen anzeigt;
ein Teilelistenfenster, das an einem unteren Teil des Teilegruppenfensters gebildet wird und eine Liste von Teilen anzeigt, die die gleichen Namen wie diejenigen der ausgewählten Teile unter den ganzen Teilen haben, die in dem Teilegruppenfenster angezeigt werden;
Tellesuche-Schaltflächen, die an dem unteren Teil des Teilegruppenfensters gebildet werden und gestatten, eine Position, eine Region und ein Untersuchungsverfahren eines Untersuchungsfensters zu lehren, wenn Teile, die nicht gelehrt werden und nicht zur Position von betreffenden Elementen bewegt werden, gesucht werden;
und eine Pauschallebr-Schaltfläche, die an dem unteren Teil der Teilesuche-Schaltfläche installiert wird, um automatisch das Untersuchungsfenster zu bilden.

9. Automatisches Lehrverfahren für ein Leiterplatten-Untersuchungssystem nach Anspruch 8, wobei das automatische Lehren in dem Lehrprozess die folgenden Prozesse umfasst:
Bewegen einer Kamera zu x- und y-Koordinaten von Teilen, die die gleichen Teilenamen haben wie Teile, die einen Referenznamen verwenden, der in den einzelnen Teilen, die in dem Teilegruppenfenster aufgelistet werden, als ein Standardname registriert ist, und automatisches Bilden eines Untersuchungsfensters mit den gleichen Attributen wie der Standardname an der Position, zu der die Kamera unter Verwendung von Winkeln der Teile bewegt wird; und
Bilden eines Untersuchungsfensters mit den gleichen Attributen wie das Standardteil unter Verwendung von Positionskoordinaten und Drehwinkeln von Teilen, die zu lehren sind, zu einer Position, die den höchsten Grad von Ähnlichkeit aufweist, nach Erfassen des Grads der Ähnlichkeit für Bilder, die ähnlich dem Standardteil sind, das in einer Kandidatenregion gefunden wurde, durch Durchrühren von Musteranpassung, in der Bilder für ein gelehrtes Standardteil mit Bilden für eine Kandidatenregion von Teilen, die zu lehren sind, verglichen werden, so dass das Untersuchungsfenster, das in dem vorherigen Schritt automatisch gebildet wurde, automatisch zu einer tatsächlichen Position von Teilen auf einer Druckleiterplatte gelehrt wird.

## Revendications

1. Procédé d'apprentissage automatique destiné à un système d'inspection de carte de circuit comprenant :
une étape de transformation de données consistant à sélectionner un menu d'édition à partir d'un écran principal fourni, via l'exécution d'un programme par des opérateurs, à appeler des données de montage sur l'écran d'édition lorsqu'un montage d'un composant sur la carte de circuit est mis en oeuvre, à désigner une zone de transformation de données, à transformer des données de montage correspondant à la zone de transformation des données de l'écran d'édition désigné en données d'apprentissage, et à stocker les résultats ;
une étape de transformation de coordonnées consistant à transformer les coordonnées correspondantes des données d'apprentissage via l'étape de transformation de données en coordonnées de système d'inspection;
dans lequel l'étape de transformation de coordonnées est mise en oeuvre par des opérateurs en sélectionnait un menu de transformation de coordonnées affiché sur un écran principal via une exécution de programme, en appelant les données d'apprentissage sur un écran de transformation de coordonnées, en désignant des composants spécifiques et en mettant en oeuvre une symétrie ou une rotation des données d'apprentissage de chacun des composants spécifiques désignés ;
une étape d'apprentissage consistant à programmer un contenu destiné à être inspecté sur la base de données d'apprentissage, telles que des coordonnées de composants, des noms de composants, des noms de références et des angles de composants qui sont formés au cours de l'étape de transformation de données et de l'étape de transformation de coordonnées.

2. Procédé d'apprentissage automatique destiné à un système d'inspection de carte de circuit selon la revendication 1, dans lequel l'étape de transformation de données comporte les étapes ci-dessous :
une première étape consistant à sélectionner un menu d'édition à partir de l'écran principal fourni, via une exécution de programme par l'utilisateur, et à afficher un écran d'édition en vue d'une transformation de données ;
une deuxième étape consistant à appeler des données de montage sur l'écran d'édition affiché au cours de la première étape ;
une troisième étape consistant à désigner une zone de transformation de données à transformer de données de montage affichées sur l'écran d'édition au cours de la deuxième étape en des données d'apprentissage ;
une quatrième étape consistant à entrer les éléments concernés en vue d'une transformation en données d'apprentissage, après analyse des données de montage désignée en tant que zone de transformation des données dans la troisième étape ;
une cinquième étape consistant à transformer les données de montage désignées, entrées lors de la quatrième étape, en des données d'apprentissage, et à stocker les résultats sous la forme d'un fichier d'apprentissage ;
une sixième étape consistant à transformer les éléments concernés destinés à être transformés de données de montage en données d'apprentissage, après analyse des données à transformer appelées lors de la deuxième étape ;
une septième étape consistant à stocker les éléments concernés transformés lors de la sixième étape et à former un fichier de données d'apprentissage, dans laquelle les sixième et septième étapes sont mises en oeuvre entre la deuxième étape consistant à appeler les données de montage et la troisième étape consistant à désigner la zone de transformation des données ; et
une huitième étape consistant à établir des règles de transformation de données entre la deuxième étape consistant à appeler les données de montage et la troisième étape consistant à désigner une zone de transformation des données.

3. Procédé d'apprentissage automatique destiné à un système d'inspection de carte de circuit selon la revendication 1, dans lequel l'étape de transformation de coordonnées comporte les étapes ci-dessous :
une onzième étape consistant à afficher un écran de transformation de coordonnées lorsqu'un utilisateur sélectionne un menu de transformation de coordonnées affiché selon une exécution de programme ;
une douzième étape consistant à afficher les données d'apprentissage stockées et transformées au cours de l'étape de transformation de données sur l'écran de transformation de coordonnées affiché au cours de la onzième étape ;
une treizième étape consistant à mettre en oeuvre une transformation de coordonnées schématique en faisant glisser les données d'apprentissage affichées sur l'écran de transformation de coordonnées au cours de la douzième étape à l'aide d'une souris, ou en mettant en oeuvre une symétrie ou une rotation desdites données ;
une quatorzième étape consistant à désigner des composants spécifiques à partir des données d'apprentissage sur lesquelles la transformation de coordonnées schématique est mise en oeuvre au cours de la treizième étape, à les déplacer à l'aide d'une souris vers le centre d'un composant qui est affiché sur une image en cours, et à mettre en oeuvre une transformation de micro-coordonnées sur les composants spécifiques ; et
une quinzième étape consistant à enregistrer les coordonnées transformées des composants spécifiques sur lesquelles la transformation de micro-coordonnées est réalisée au cours de la quatorzième étape.

4. Procédé d'apprentissage automatique destiné à un système d'inspection de carte de circuit selon la revendication 1, dans lequel l'étape d'apprentissage comporte les étapes ci-dessous :
une vingt-et-unième étape consistant à afficher un écran d'apprentissage lorsqu'un utilisateur sélectionne un menu d'apprentissage à partir d'un écran principal affiché via une exécution de programme ;
une vingt-deuxième étape consistant à indiquer une liste soumise à apprentissage sur l'écran d'apprentissage affiché au cours de la vingt-ét-unième étape, à sélectionner une cible d'apprentissage dans la liste affichée soumise à apprentissage et à mettre en oeuvre un apprentissage sur la cible d'apprentissage sélectionnée ;
une vingt-troisième étape consistant à achever l'apprentissage suite à une génération de trame lorsque l'apprentissage mis en oeuvre lors de la vingt-deuxième étape est terminé.

5. Procédé d'apprentissage automatique destiné à un système d'inspection de carte de circuit selon la revendication 2, dans lequel l'écran d'édition comprend :
une fenêtre de génération en sortie de données de montage en vue de générer en sortie les données de montage appelées à partir de l'écran d'édition de la deuxième étape ;
une fenêtre de définition d'environnement laquelle est formée sur un côté de la fenêtre de génération en sortie de données de montage de sorte que l'utilisateur définit différents paramètres pour transformer les données de montage ; et
une fenêtre de génération en sortie de données de transformation laquelle est formée sur un côté de la fenêtre de génération en sortie de données de montage en vue de générer en sortie des données de transformation pour les données de montage désignées au cours de la troisième étape.

6. Procédé d'apprentissage automatique destiné à un système d'inspection de carte de circuit selon la revendication 5, dans lequel la fenêtre de définition d'environnement comporte :
une référence de coordonnées pour établir un système de coordonnées des données de montage ;
une unité directionnelle pour établir une unité d'angle de rotation des données de montage ;
une unité de coordonnées pour sélectionner une unité de coordonnées des données de montage ;
un séparateur pour définir un symbole à répartir entre les éléments des données de montage ; et
une partie de sélection de type de montage pour définir une référence de coordonnées,
une unité directionnelle et une unité de coordonnées, de sorte que les opérateurs sélectionnent et réutilisent le type de montage sélectionné non pas en redéfinissant l'environnement pour le type de données stockées, mais en sélectionnant le type de montage uniquement.

7. Procédé d'apprentissage automatique destiné à un système d'inspection de carte de circuit selon la revendication 3, dans lequel l'écran de transformation de coordonnées comporte :
une fenêtre d'affichage d'images de carte de circuit pour afficher des images entières de la carte de circuit et la position de chacun des composants entrés dans le fichier de données d'apprentissage sous une forme de croix, et pour afficher la position de composants spécifiques sélectionnés sous une forme rectangulaire, de sorte que les composants spécifiques sont distingués des composants génériques;
une fenêtre de transformation de coordonnées laquelle est formée sur un côté de la fenêtre d'affichage d'images de carte de circuit pour afficher des informations connexes à des coordonnées transformées de chacun des composants ;
un bouton symétrique / de rotation lequel est formé sur un côté de la fenêtre d'affichage d'images de carte de circuit et permet la mise en oeuvre d'une transformation symétrique ou rotationnelle sur chacun des composants entrés dans le fichier de données d'apprentissage, en vue de mettre en correspondance des images de composants et des repères, en faisant glisser la souris, la souris étant adaptée au système de coordonnées ;
un bouton de déplacement lequel est formé sur un côté de la fenêtre d'affichage d'images de carte de circuit et permet à un appareil photographique de se déplacer vers la position de composants affichés sur la fenêtre de transformation de coordonnées, afin de mettre en correspondance le point central d'images de composants d'une image projetée sur une fenêtre d'affichage d'image et des coordonnées de composants sélectionnées sur la fenêtre d'information de transformation de coordonnées par le biais d'un glisser de la souris réalisé par les opérateurs ; et
un bouton d'enregistrement lequel est formé sur un côté du bouton de déplacement et permet 1'enregistrement de coordonnées transformées.

8. Procédé d'apprentissage automatique destiné à un système d'inspection de carte de circuit selon la revendication 4, dans lequel l'écran d'apprentissage comporte :
une fenêtre d'affichage d'images destinée à afficher des images de composants faisant l'objet d'un apprentissage ;
une fenêtre d'outil d'apprentissage automatique laquelle est formée sur un côté de la fenêtre d'affichage d'images ;
une fenêtre de groupes de composants laquelle est formée sur la partie supérieure de la fenêtre d'outil d'apprentissage automatique et affiche une liste de composants entiers ;
une fenêtre de listes de composants laquelle est formée sur une partie inférieure de la fenêtre de groupes de composants et affiche une liste de composants ayant le même nom que des composants sélectionnés parmi les composants entiers affichés dans la fenêtre de groupes de composants ;
des boutons de recherche de composants lesquels sont formés sur la partie inférieure de la fenêtre de groupes de composants et autorisent l'apprentissage d'une position, d'une zone et d'un procédé d'inspection d'une fenêtre d'inspection lorsque des composants, qui n'ont pas fait l'objet d'un apprentissage et qui n'ont pas été déplacés à la position des composants concernés, sont recherchés ; et
un bouton d'apprentissage global lequel est installé sur la partie inférieure des boutons de recherche de composants pour former automatiquement la fenêtre d'inspection.

9. Procédé d'apprentissage automatique destiné à un système d'inspection de carte de circuit selon la revendication 8, dans lequel l'apprentissage automatique dans l'étape d'apprentissage comprend les étapes ci-après consistant à :
déplacer un appareil photographique vers des coordonnées x et y de composants présentant les mêmes noms de composants que des composants qui utilisent un nom de référence lequel est enregistré dans chacun des composants répertoriés dans la fenêtre de groupes de composants sous un nom standard, et former automatiquement une fenêtre d'inspection présentant le même attribut que le nom standard à la position à laquelle l'appareil photographique se déplace en utilisant des angles des composants ; et
former une fenêtre d'inspection présentant le même attribut que le composant standard, en utilisant des coordonnées de position et des angles de rotation de composants faisant l'objet d'un apprentissage, à une position présentant le plus haut degré de similitude, après saisie du degré de similitude d'images similaires au composant standard trouvées dans une zone candidate, en mettant en oeuvre une correspondance de modèles dans laquelle des images d'un composant standard ayant fait l'objet d'un apprentissage sont comparées à des images d'une zone candidate de composants faisant l'objet d'un apprentissage, de sorte que la fenêtre d'inspection formée automatiquement au cours de l'étape précédente est automatiquement apprise à une position en cours de composants sur une carte de circuit imprimé.
